# EUROPÄISCHE PATENTANMELDUNG

(11) **EP 0 641 029 A2**
(43) Veröffentlichungstag der Anmeldung: **01.03.1995**
(21) Anmeldenummer: 94113324.1
(22) Anmeldetag: 25.08.1994
(51) Int. Cl.: H01L 31/0352, H01L 31/18

(54) **Element einer photovoltaischen Solarzelle und Verfahren zu seiner Herstellung sowie deren Anordnung in einer Solarzelle**

(30) Priorität: 27.08.1993 DE 4328868; 28.10.1993 DE 4336825
(71) Anmelder: Twin Solar-Technik Entwicklungs-GmbH, D-01324 Dresden (DE)
(72) Erfinder: Hoegl, Helmut Dr., D-82049 München / Pullach (DE); Kern, Ralf M., D-82057 Icking (DE)
(74) Vertreter: Kern, Ralf M., Dipl.-Ing.

(57) **Zusammenfassung**

Die Erfindung betrifft ein Element einer photovoltaischen Solarzelle mit mindestens einer langgestreckten bzw. stab- oder draht- (bzw. faden- ) oder bandförmigen Elektrode, welche auf ihrer Oberfläche mindestens eine photovoltaisch wirksame Beschichtung aufweist, und ist dadurch gekennzeichnet, daß die Elektrode aus einem elektrisch leitenden Material, insbesondere unreinem Silizium mit multikristallinem, vorzugsweise monokristallinem Gefüge und die Beschichtung aus einem auf der Oberfläche der Elektrode mono- oder multikristallinen photovoltaisch wirksamen Material, insbesondere Silizium mit einer bestimmten Dotierung (p- oder n- Dotierung) besteht, welches z.B. mittels einer Draht-Ziehdüse kontinuierlich aufgebracht ist.

## Beschreibung

Die Erfindung betrifft ein Element einer photovoltaischen Solarzelle mit mindestens einer langgestreckten bzw. stab- oder draht (bzw. faden-) oder bandförmigen Elektrode, welche auf ihrer Oberfläche mindestens eine photovoltaisch wirksame Beschichtung aufweist sowie ein Verfahren zu seiner Herstellung sowie deren Anordnung in einer photovoltaischen Solarzelle.

Aufgabe der Erfindung ist es, eine bezüglich seiner Herstellungskosten und seines Wirkungsgrades verbessertes Element für photovoltaische Solarzellen sowie eine dementsprechend verbesserte Solarzelle zu schaffen.

Demgemäß besteht die Erfindung darin, daß die Elektrode aus einem elektrisch gut leitenden Material, insbesondere unreinem Silizium mit multi- oder polykristallinem, vorzugsweise monokristallinem Gefüge und die Beschichtung aus einem auf der Oberfläche der Elektrode mono- oder multikristallinem photovoltaisch wirksamen Material, insbesondere Silizium mit einer bestimmten Dotierung (p- oder n-Dotierung) besteht.

In bevorzugter Ausführungsform besteht also sowohl die den Strom leitende Elektrode als auch deren Beschichtung aus Silizium, jedoch mit unterschiedlichem Aufbau, nämlich der Elektrode aus unreinem, gut Strom leitendem und der Beschichtung aus möglichst reinem, aber zwecks photovoltaisch optimaler Wirksamkeit gezielt dotiertem Silizium höheren Reinheitsgrades.

Grundsätzlich würde eine einzige solche Beschichtung auf einer Siliziumelektrode ausreichen, indem das in der Beschichtung gebildete Ladungsfeld (p- oder n) mit den entgegengesetzten Ladungsträgern innerhalb der Elektrode das photovoltaische Spannungsfeld bzw. die zwei entgegengesetzten Ladungsfelder bildet, während die demgegenüber überschüssigen, d.h. gegenüber dem quantitativ in der Beschichtung gebildeten Ladungspotential zusätzlich in der Elektrode gegebenen frei beweglichen Ladungsträger der verbesserten elektrischen Leitfähigkeit der Si-Elektrode dienen.

Sinngemäß kann der Randbereich in der Elektrode bei entsprechender Zusammensetzung des Siliziums ein positives oder negatives Ladungsfeld aufweisen und die Beschichtung entsprechend entgegengesetzt (p- oder n) dotiert sein.

Bei der Verwendung von Silizium als Elektrodenmaterial kann das Elektrodengefüge multikristallin aufgebaut sein, so daß die Beschichtung aufgrund epitaktischer Wirkung entsprechend grob-kristallin, insbesondere auch monokristallin aufgebaut sein kann.

Analoge Effekte können auch mit anderen Materialien zum Einsatz gebracht werden, auch z.B. Siliziumcarbid.

Die Erfindung ist mit den Merkmalen der Patentansprüche 2 und 3 modifizierbar und besteht in einer Solarzellenanordnung gemäß den Patentansprüchen 4 bis 11 und umfaßt auch das Herstellungsverfahren gemäß den weiteren Patentansprüchen.

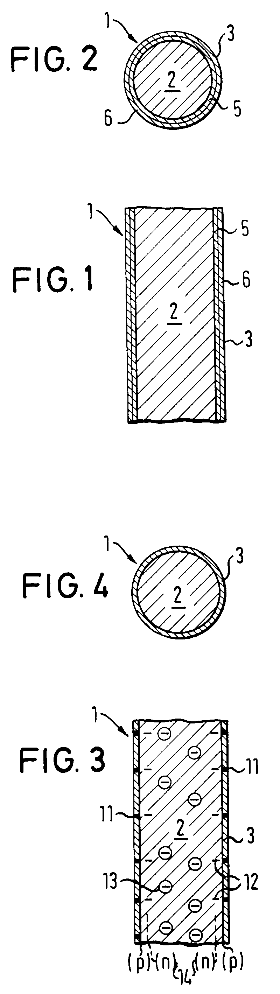

Die Erfindung ist nachstehend anhand von Figuren 1 bis 9 näher erläutert:
Gemäß Fig. 1 und 2 ist im Längsschnitt und im Querschnitt eine aus Silizium gezogene langgestreckte bzw. geformte langgestreckte, z.B. draht- und bandförmige Elektrode 2 mit einer photovoltaisch wirksamen Beschichtung 3 versehen, welche aus einer radial inneren Lage 5 und einer darauf angebrachten äußeren Lage 6 bestehen kann, wobei die Lagen 5 und 6 entgegengesetzt dotiert sind (p- bzw. n).

In den Fig. 3 und 4 ist analog eine Elektrode 2 jedoch mit nur einer Beschichtung 3 aus nur einer einzelnen Lage bestimmter Dotierung (p- oder n - hier p) dargestellt. Dabei kann sich beidseits der Beschichtungsgrenze auf der Oberfläche der Elektrode eine Ladungsfeldtrennung aus Elektronen 12 (-) und - in der Beschichtung 3 - aus "Löchern" (p) bzw. + bilden, während ein Elektronenüberschuß 13 einer Erhöhung der elektrischen Leitfähigkeit des Siliziums dienen kann.

Auch kann z.B. durch Diffusionseinwirkung (oder andere Effekte) eine Dotierungsschicht 14 in die Oberfläche der Elektrode 2 hineinverlagert werden, insbesondere nach vorheriger Diffusionsreinigung bzw. Beeinflussung dicht unter der Oberfläche des Elektrodenmaterials.

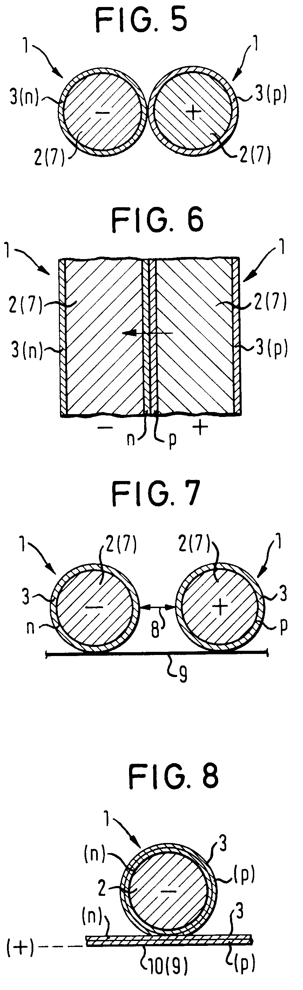

Beim Aneinanderfügen zweier Elemente aus beschichteten Elektroden 2 gemäß den Fig. 5 und 6 bildet sich zwischen den Elektroden 2 bzw. als Anordnung zweier jeweils als Elektrode 2 und Gegenelektrode 7 mit jeweils entgegengesetzter Dotierung ihrer Beschichtungsoberflächen eine photovoltaische Solarzelle, so daß der Strom radial durch die Beschichtungen 3 zwischen den Elektroden 2 und 7 fließt.

Gemäß Fig. 7 können jeweils zwei auf der Oberfläche ihrer Beschichtung 3 entgegengesetzt dotierte Elemente 1 auf einer metalischen Fläche (die auch reflektierend ausgeführt sein kann) entweder auf Abstand 8 oder auch aneinander (analog Fig. 5 und 6) elektrisch leitend verbunden angebracht sein.

Gemäß Fig. 8 kann die Fläche 9 als photovoltaisches Element auf der den Elementen 1 zugewandten Seite ebenfalls mit einer photovoltaisch wirksamen Beschichtung 3 versehen sein, auf der die Elemente 1 elektrisch leitend angebracht sind. Dabei wirkt die photovoltaisch beschichtete Fläche 10 als Gegenelektrode, während die Elemente 1 mit zur Oberfläche der photovoltaischenen Beschichtung entgegengesetzt dotierter Beschichtungsoberfläche auf lateralen Abstand (8 analog Fig. 7) auf der Oberfläche der photovoltaischen Beschichtung elektrisch leitend verbunden sind.

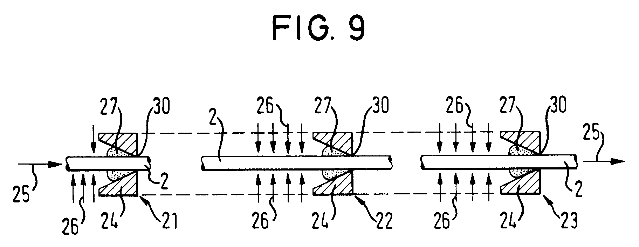

Fig. 9 zeigt ein Auftragungsverfahren mittels Aufbringung des Beschichtungsmaterials durch kontinuierliches Hindurchziehen z.B. eines Elektrodendrahtes 2 aus unterschiedlichen Materialien wie Metallen (z.B. Kupfer, Aluminium, Wolfram, V₂A-Stahl), auf dem in Laufrichtung 25 vor den Ziehsteinen 24 das Auftragen 26 des Beschichtungsmaterials 27 erfolgt, das sich auch vor jeder Ziehdüse der einzelnen Ziehstationen 21-13 stauen kann.

Mit diesem Verfahren kann auch das Gefüge und der Querschnitt des Elektrodendrahtes selbst beeinflußt werden. Jedenfalls läßt sich unter den Druckverhältnissen innerhalb der Ziehdüse eine gesteuerte Gefügeausbildung, eine optimal enge und verunreinigungsfreie Verbindung mehrerer Schichten miteinander bzw. auf der Oberfläche der Elektrode mit optimaler Gleichmäßigkeit und dünnschichtiger Schichtdicke erreichen.

Unter den Druckverhältnissen innerhalb der Ziehdüse sind auch chemische Veränderungen (z.B. Oxidation bei Kupfer) der Elektrodenoberfläche oder der Auftragsmaterialien wie auch z.B. interkristalline Verbindungen möglich.

Die Beschichtung der langgestreckten draht-, stab- (bzw. faden-) oder bandförmigen Elektrode kann am einfachsten mittels liquid phase epitaxy (LPE) erfolgen, bei dem eine insbesondere makrokristalline, vorzugsweise sehr weitgehend monokristalline Siliziumbeschichtung auf folgende Weise gebildet wird:
Für p-Siliziumschichten wird Silizium auch gleich zusammen mit der benötigten Dotierung in flüssigem INDIUM oder GALLIUM oder auch Wismut oder Legierungen aus dieser gelöst, und zwar vorzugsweise gesättigt oder übersättigt, die zu beschichtende Oberfläche unter reduzierender Atmosphäre, wie z.B. in Wasserstoffgas, in die Schmelze derart eingebracht, daß bei Senkung der Temperatur an der Drahtoberfläche das Silizium in weitgehend monokristalliner Form mitsamt des Dotierungsmittels in gewünschter Dotierungskonzentration abgeschieden wird.

Für eine Beschichtung in n-dotierter Form wird eine AsIn Schmelze als Lösungsmittel für das Silizium samt Dotierungsmittel bevorzugt.

Der für das Kristallwachstum verwendete Temperaturbereich kann zwischen 250° bis 940°C liegen, bei mit einer Abkühlungsrate von 5° bis 16° C/h. Die Kristallorientierung des Substrats kann bei [100] oder [111] oder in anderen Längen liegen.

Für die Abscheidung von Gallium-Arsenide Schichten werden analog Ga, GaGe oder Ga-Si-Legierungen als Lösungsmittel eingesetzt, wobei der Schichtwachstums-Temperaturbereich bei 300° bis 750°C bei gleicher oder ähnlicher Abkühlungsgeschindigkeit liegt und die bevorzugte Substrat-Orientierung [100] oder [111]. Auf diese Weise können auch mehrere Schichten nacheinander übereinander auf die Drahtoberfläche aufgetragen werden. Auch kann erfindungsgemäß zunächst die Oberfläche des Substrats chemisch verändert oder diffusionsmäßig dotiert bzw. zu einer ersten integrierten photovoltaischen Schicht (p oder n) umgewandelt werden, bevor - ggf. nach Reinigung der Oberfläche z B. in einer Ziehdüse bzw. einem Zieh- odern Abstreifstein - die Siliziumschichten in vorstehender Weise aufgebracht werden.

Auch können dabei profilierte bzw. texturierte Oberflächen gebildet werden, beispielsweise Draht- oder langgestreckte Profile mit längsverlaufenden Rillen.

Mit dem genannten Verfahren können z.B. Schichtdicken zwischen 0,5 µ und 100 µ abgeschieden werden. Verfahrensgemäß wird ein Draht, beispielsweise ein Siliziumdraht oberflächenmäßig gereinigt (auch z.B. durch Ziehen in einem Ziehstein bzw. Ziehprofil oder mittels Ätzen) und dann durch nacheinander geschaltete Abscheidebäder durchgezogen, in denen - bei wahlweiser Geschwindigkeit und Einwirkungs- bzw. Eintauchlänge - die Siliziumbeschichtung mit - je nach Folge der Abscheidebäder - wahlweiser Schichtdicke und Aufeinanderfolge der n- und der p-Schicht erfolgt. Der auf diese Weise beschichtete Formdraht kann anschließend mittels Ziehen durch einen Ziehstein gefügeverfestigt werden.

Eine besonders vorteilhafte Schichtfolge liegt in einer Siliziumbeschichtung eines auf seiner Oberfläche verchromten oder auch verzinkten oder cadmierten drahtförmigen bzw. langgestreckten Substrats (auch aus C-Faser), wobei zugleich eine radialinnere Hinterspiegelung der photovoltaischen Schichten mit entsprechend hohem Wirkungsgrad gegeben ist.

Ähnliche photovoltaische Beschichtungen sind mit Molekularstrahl Epitaxy-Verfahren erzielbar.

Analog zu der vorbeschriebenen Form und bevorzugten Ausführungsform kann zugleich eine als Träger dienende langgestreckte Elektrode von außen bis in ihre Oberfläche hinein chemisch behandelt sein, so daß der äußere Bereich ihres Querschnitts je nach Material der Elektrode im Sinne eines photovoltaisch wirksamen Randbereiches oder dessen photovoltaische Wirkung begünstigenden Randbereich umgewandelt wird.

Beispiele dafür sind Zinkoxid bei einer aus Zink bestehenden Elektrode, Kupferoxid (CuO) oder Kupferoxidul (CuO₂) bei einer aus Kupfer bestehenden Elektrode, oder auch z.B. Magnesiumoxid bei einer aus Magnesium bestehenden Elektrode.

Auch kann das metallische Elektrodenmaterial derart legiert oder gefügemäßig ausgebildet sein, daß dessen chemische Behandlung eine photovoltaisch günstige Mischverbindung ergibt, auch eventuell zugleich mit Dotierungseffekt.

Bei Silizium als Elektrodenmaterial kann für den Fall einer Beschichtung mit z.B. Silizium nach Art der MIS-Zellen (Feldladungsstrang) der Oberflächenbereich zu einer der zwischen der auf dem Umfang befindlichen photovoltaischen Material und der Oberfläche der Elektrode vorgesehenen dünnen SiO₂-Schicht umgewandelt werden, um die Elektronen zur Elektrode zu tunneln.

Wenn sämtliche beschriebenen fadenförmigen bzw. langgestreckten Elektroden jeweils mit mindestens einer photoaktiven p-dotierten und einer darüber n-dotierten - oder umgekehrt - Oberflächenschicht versehen sind, können sie auch in identischer Anordnung vorgesehen sein, wobei alle Elektroden auf ihrer äußeren Oberfläche die gleiche Ladungspolarität (also p⁺ oder e⁻) aufweisen, und auch nebeneinander bzw. miteinander, auch aneinander auf einem elektrisch leitenden Träger als Gegenelektrode, z.B. als Fläche angeordnet sein können und damit unmittelbar in elektrisch leitenden Kontakt stehen. Dabei bilden jeweils alle Elektrodendrähte den einen (+ oder -) Pol, zu dem der elektrisch leitende Träger für alle Elektrodendrähte die Gegenelektrode ist. Dabei kann elektrisch leitender Klebstoff zur Kontaktverbindung aller Elektrodendrähte aneinander und/oder zur Befestigung auf der Trägeroberfläche verwendet werden.

Auch die Aufbringung des Klebstoffs kann zwecks geringstmöglicher Dicke in einer Linie mittels des Ziehverfahrens in einem gleichzeitigen, kombinierten Verfahrenszug, ähnlich dem und folgend auf den der Fig. 9, erfolgen.

## Patentansprüche

1. Element einer photovoltaischen Solarzelle mit mindestens einer langgestreckten bzw. stab- oder draht(bzw. faden-) oder bandförmigen Elektrode, welche auf ihrer Oberfläche mindestens eine photovoltaisch wirksame Beschichtung aufweist, **dadurch gekennzeichnet,** daß die Elektrode **(2)** aus einem elektrisch gut leitenden Material, insbesondere unreinem Silizium mit multikristallinem, vorzugsweise monokristallinem Gefüge und die Beschichtung **(3)** aus einem auf der Oberfläche **(4)** der Elektrode mono- oder multi- bzw. polykristalinen photovoltaisch wirksamen Material, insbesondere Silizium mit einer bestimmten Dotierung (p- oder n-Dotierung) besteht.

2. Element einer photovoltaischen Solarzelle nach Anspruch 1, **dadurch gekennzeichnet,** daß die Beschichtung **(3)** aus zwei koaxialen Lagen **(5, 6)** von entgegengesetzt dotiertem Material besteht.

3. Element einer photovoltaischen Solarzelle nach einem der Ansprüche 1 oder 2, **dadurch gekennzeichnet,** daß mindestens die äußere photovoltaisch wirksame Lage **(6)** der Beschichtung **(3)** ein poly- bzw. mikrokristallines oder amorphes Gefüge aufweist.

4. Solarzellenanordnung mit mindestens einem der Elemente nach den Ansprüchen 1 bis 3 und einer Gegenelektrode, **dadurch gekennzeichnet**, daß eine andere langgestreckte bzw. stab- oder draht- oder bandförmige Elektrode **(7)** als Gegenelektrode mit mindestens einer photovoltaisch wirksamen Beschichtung **(3)** mit auf ihrer Oberfläche entgegengesetzt zur Elektrode **(2)** gegebener Dotierung elektrisch leitend verbunden ist.

5. Solarzellenanordnung nach Anspruch 4, **dadurch gekennzeichnet,** daß die auf ihrer Oberfläche n- oder p-beschichtete Elektrode **(2)** und die Gegenelektrode **(7)** mit ihren Oberflächen elektrisch leitend aneinander angeordnet sind bzw. in elektrisch leitendem Kontakt stehen.

6. Solarzellenanordnung nach Anspruch 4, **dadurch gekennzeichnet,** daß Elektrode **(2)** und Gegenelektrode **(7)** parallel auf Abstand zueinander auf einer elektrisch leitenden Fläche **(9)** angeordnet und mit ihren Oberflächen über diese elektrisch leitend verbunden sind bzw. in Kontakt stehen.

7. Solarzellenanordnung nach Anspruch 6, **dadurch gekennzeichnet,** daß eine flächige Gegenelektrode **(7)** mit mindestens einer photovoltaisch wirksamen Beschichtung **(10)** von zur Beschichtung **(3)** der Elektrode **(2)** entgegengesetzter Dotierung (p- oder n-) versehen ist, an deren Oberfläche die Beschichtung der Elektroden elektrisch leitend angebracht ist.

8. Solarzellenanordnung nach einem der Ansprüche 4 bis 7, **dadurch gekennzeichnet,** daß als Verbindung der Oberflächen der Beschichtung **(3)** der Elektroden **(2)** mit der Gegenelektrode **(7)** ein elektrisch leitender Klebstoff verwendet ist.

9. Solarzellenanordnung nach einem der Ansprüche 4 bis 7, **dadurch gekennzeichnet,** daß die Oberfläche der Beschichtung **(3)** der Elektroden **(2)** und der Gegenelektroden **(7)** bzw. Gegenelektroden miteinander elektronenstrahl- oder laserverschweißt sind.

10. Solarzellenanordnung nach einem der Ansprüche 4 bis 7, **dadurch gekennzeichnet,** daß mindestens eine der photovoltaischen Schichten **(3)** in die Oberfläche der Elektrode **(2)** chemisch oder gefügemäßig eingearbeitet ist bzw. aus einer Umwandlung der Oberfläche der Elektrode **(2)** besteht.

11. Solarzellenanordnung nach einem der vorhergehenden Ansprüche 6 und 7, **dadurch gekennzeichnet,** daß die Oberflächen der elektrisch leitenden Flächen **(9)** reflektierend bzw. verspiegelt ausgebildet sind.

12. Verfahren zur Herstellung eines Elements für eine photovoltaische Zelle nach einem der vorhergehenden Ansprüche 1 bis 11, **dadurch gekennzeichnet,** daß die insbesondere aus unreinem Silizium bestehende Elektrode nach ihrer Ausbildung zu langgestreckter bzw. stab- oder draht- (bzw. faden-) oder bandförmiger Form zur Bildung einer multi- oder polylkristallinen, vorzugsweise monokristallinen Beschichtung durch eine Schmelze aus n- oder p-dotiertem Beschichtungsmaterial, vorzugsweise reinem Silizium bewegt wird.

13. Verfahren zur Herstellung eines Elements für eine photovoltaische Zelle nach einem der vorhergehenden Ansprüche 1 bis 12, **dadurch gekennzeichnet,** daß die Beschichtung mittels Elektronenstrahlverfahren, insbesondere ionengestütztem Elektronenstrahlverfahren, erfolgt (Dotierung n = Antimon oder Phosphor; Dotierung p = Gallium).

14. Verfahren zur Herstellung eines Elements für eine photovoltaische Zelle nach einem der vorhergehenden Ansprüche 1 bis 13, **dadurch gekennzeichnet,** daß die Beschichtung elektrolytisch aufgetragen wird.

15. Verfahren zur Herstellung eines Elements für eine photovoltaische Zelle nach einem der vorhergehenden Ansprüche 1 bis 14, **dadurch gekennzeichnet,** daß die Beschichtung aus der Gasphase (z.B. Silan) erfolgt.

16. Verfahren zur Herstellung eines Elements für eine photovoltaische Zelle nach einem der vorhergehenden Ansprüche, **dadurch gekennzeichnet,** daß die Beschichtung elektrophoretisch aufgetragen wird.

17. Verfahren zur Herstellung eines Elements für eine photovoltaische Zelle nach einem der vorhergehenden Ansprüche 1 bis 10, **dadurch gekennzeichnet,** daß das Material der Oberfläche der Elektrode chemisch umgewandelt wird.

18. Verfahren zur Herstellung eines Elements für eine photovoltaische Zelle nach einem der vorhergehenden Ansprüche 1 bis 10, **dadurch gekennzeichnet,** daß die Beschichtung mittels Auftragen des photovoltaischen Materials wie z.B. Sputtern, Besprühen, Laserbeschichten, elektrostatisch Beschichten, Elektrodenstrahlbeschichten, Aufdampfen oder Aufsintern erfolgt und das aufgetragene Material mittels Ziehen durch Ziehdüsen bzw. Ziehsteine auf oder in die Oberfläche des Materials der Elektrode auf- bzw. eingearbeitet wird.

19. Verfahren nach Anspruch 17, **dadurch gekennzeichnet,** daß die Beschichtung in mehreren Auftrag- und Ziehstationen im kontinuierlichen Durchzug angebracht wird.

20. Verfahren nach Anspruch 17 und/oder 18, **dadurch gekennzeichnet,** daß mehrere photovoltaische Schichten nacheinander aufgetragen werden.

21. Verfahren nach einem der Ansprüche 11 bis 20, **dadurch gekennzeichnet,** daß der Auftrag der Beschichtung unter gleichzeitiger Anwendung von Mikrowellen erfolgt.
